# EUROPEAN PATENT APPLICATION

(11) **EP 4 368 317 A1**
(43) Date of publication of application: **15.05.2024**
(21) Application number: 22837650.5
(22) Date of filing: 04.07.2022
(51) Int. Cl.: B22F 9/00, B22F 1/00, B22F 7/08, C09J 9/02, H01B 1/22, H01L 21/52

(54) **METAL PASTE FOR JOINING, JOINT, AND MANUFACTURING METHOD THEREFOR**

(30) Priority: 06.07.2021 JP 2021112199
(71) Applicant: Resonac Corporation, Tokyo 105-7325 (JP)
(72) Inventor: NAKAKO, Hideo, Tokyo 100-6606 (JP); EJIRI, Yoshinori, Tokyo 100-6606 (JP); TANAKA, Toshiaki, Tokyo 100-6606 (JP); ISHIKAWA, Dai, Tokyo 100-6606 (JP); NATORI, Michiko, Tokyo 100-6606 (JP)
(74) Representative: Kraus & Lederer PartGmbB
(86) International application number: PCT/JP2022/026625
(87) International publication number: WO 2023/282235

(57) **Abstract**

A metal paste for bonding includes metal particles, a dispersion medium, a reducing agent, and a reduction aid, in which the metal particles contain copper particles, the reduction aid includes a coordinating compound having electron back-donation properties, the coordinating compound is at least one selected from the group consisting of an organic phosphorus compound and an organic sulfur compound, and the metal paste for bonding contains, as a reducing agent, 1.6 parts by mass or more and 10 parts by mass or less of a polyol-based compound with respect to 100 parts by mass of the total mass of the copper particles.

## Description

### Technical Field

The present invention relates to a metal paste for bonding, a bonded body, and a method for manufacturing the bonded body.

### Background Art

When manufacturing a semiconductor device, various bonding materials are used to form a bonding layer that bonds a semiconductor element with a lead frame or the like (supporting member). For example, for the bonding of a power semiconductor, an LSI, and the like, which are operated at a temperature up to about 150°C, high-lead solder has been used for forming a bonding layer. In recent years, capacity increase of semiconductor elements and space saving are in progress, and there is an increasing demand for operating semiconductor at a high temperature of 175°C or higher. In order to secure the operational stability of such a semiconductor device, the bonding layer is required to have connection reliability and high thermal conductivity characteristics. However, in a temperature range of 175°C or higher, conventionally used high-lead solder bonding layers have a problem with connection reliability and also have insufficient thermal conductivity (30 Wm⁻¹K⁻¹), and therefore, alternate materials are required.

As one of the alternate materials, a sintered silver layer formed by a sintering phenomenon of silver particles has been proposed (see the following Patent Literature 1). A sintered silver layer has been reported to have high thermal conductivity (> 100 Wm⁻¹K⁻¹) and high connection reliability over power cycles, and attention has been paid thereto (see the following Non Patent Literature 1). However, in order to secure connection reliability, a thermocompression bonding process that involves high pressure is essential for improving the density of the sintered silver layer, and there are problems such as damage of semiconductor element chips and a decrease in the throughput of the thermocompression bonding process. Furthermore, there is also a problem that the material cost of silver is high.

As another alternate material, a sintered copper layer using copper has been proposed. Copper has excellent mechanical strength compared to silver, high-temperature reliability can be easily obtained without increasing the density as much as a sintered silver layer, and the material cost can also be suppressed to a low level. As such a sintered copper layer, a sintered copper layer obtained by reducing and sintering copper oxide particles has been proposed (see the following Patent Literature 2 and the following Non Patent Literature 2).

### Citation List

### Patent Literatures

Patent Literature 1: Japanese Patent No. 4247800
Patent Literature 2: Japanese Patent No. 5006081

### Non Patent Literatures

Non Patent Literature 1: R. Khazaka, L. Mendizabal, D. Henry: J. ElecTron. Mater, 43(7), 2014, 2459-2466
Non Patent Literature 2: T. Morita, Y Yasuda: Materials Transactions, 56(6), 2015, 878-882

### Summary of Invention

### Technical Problem

Regarding members of LED chips, GaN on Si chips, and the like, it is desirable that the members are not subjected to any pressure other than the weight of the member and the weight of a weight used to prevent inclination of chips or void reduction. However, in order to form sintered copper having sufficient bonding strength under such non-pressurized conditions, it is necessary to reduce and sinter copper oxide particles in a hydrogen atmosphere, and when the hydrogen concentration is more than 10%, there is a possibility that restrictions may occur, such as a countermeasure of making the facilities in use explosion-proof.

Thus, an object of the present invention is to provide a metal paste for bonding, with which a bonded body having sufficient bonding strength can be obtained even in a case where bonding is achieved under no added pressure conditions in an atmosphere including no hydrogen or having a low hydrogen concentration, and a method for manufacturing a bonded body.

### Solution to Problem

An aspect of the present invention provides a metal paste for bonding including metal particles, a dispersion medium, a reducing agent, and a reduction aid, in which the metal particles contain copper particles, the reduction aid includes a coordinating compound having electron back-donation properties, the coordinating compound is at least one selected from the group consisting of an organic phosphorus compound and an organic sulfur compound, and the metal paste for bonding contains, as the reducing agent, 1.6 parts by mass or more and 10 parts by mass or less of a polyol-based compound with respect to 100 parts by mass of a total mass of the copper particles.

According to the above-described metal paste for bonding, even in a case where members are bonded under no added pressure conditions in an atmosphere that does not include hydrogen or has a low hydrogen concentration, sufficient bonding strength can be obtained.

Incidentally, the term "no added pressure" as used in the present specification means a state in which the copper paste for bonding is subjected only to the weight of the members to be bonded, or only to the weight of a weight (a pressure of 0.01 MPa or less as calculated in terms of pressure) used for prevention of chip tilting or void reduction in addition to the weight of the members.

The coordinating compound may have a lone pair of electrons and a vacant π-electron orbital.

The coordinating compound may be at least one selected from the group consisting of an organic phosphorus compound represented by the following Formula (1) and an organic phosphorus compound represented by the following Formula (2). 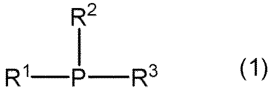 [In which in Formula (1), R¹, R², and R³ each independently represent a monovalent organic group or -OR (R represents a monovalent organic group); and R¹, R², and R³ may form a ring.] 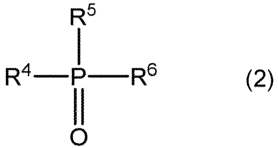 [In which in Formula (2), R⁴, R⁵, and R⁶ each independently represent a monovalent organic group or -OR (R represents a monovalent organic group); and one or more of R⁴, R⁵, and R⁶ are -OR (R represents a monovalent organic group).]

A content of the reduction aid may be 0.5 parts by mass or more and 10 parts by mass or less with respect to 100 parts by mass of the total mass of the copper particles.

The copper particles may include copper sub-microparticles having a volume average particle size of 0.15 µm or more and 0.8 µm or less and copper microparticles having a volume average particle size of 2 µm or more and 50 µm or less, a sum of a content of the copper sub-microparticles and a content of the copper microparticles may be 80% by mass or more based on the total mass of the metal particles, and the content of the copper sub-microparticles may be 30% by mass or more and 90% by mass or less based on a sum of a mass of the copper sub-microparticles and a mass of the copper microparticles.

The copper microparticles may be flake-shaped.

Another aspect of the present invention provides a method for manufacturing a bonded body, the method including a step of preparing a laminated body having a first member, the metal paste for bonding according to the above-described one aspect of the present invention, and a second member laminated in this order; and a sintering step of sintering the metal paste for bonding in the laminated body.

According to the above-described method for manufacturing a bonded body, a bonded body having a bonding strength that is sufficient even in a case where the metal paste for bonding is sintered in the sintering step under no added pressure conditions in an atmosphere that does not include hydrogen or has a low hydrogen concentration, can be obtained.

The sintering step may be a step of sintering the metal paste for bonding under no added pressure conditions in an oxygen-free atmosphere.

At least one of the first member and the second member may be a semiconductor element.

Another aspect of the present invention provides a bonded body including a first member, a second member, and a sintered body of the metal paste for bonding according to the above-described one aspect of the present invention, the sintered body bonding the first member and the second member.

### Advantageous Effects of Invention

According to the present invention, a metal paste for bonding, with which a bonded body having sufficient bonding strength even in a case of bonding under no added pressure conditions in an atmosphere that does not include hydrogen or has a low hydrogen concentration can be obtained, and a method for manufacturing a bonded body can be provided.

### Brief Description of Drawings

FIG. 1 is a schematic cross-sectional view illustrating an example of a bonded body manufactured by using a metal paste for bonding of the present embodiment.
FIG. 2 is a schematic cross-sectional view illustrating an example of a bonded body manufactured by using a metal paste for bonding of the present embodiment.
FIG. 3 is a SEM image showing a bonding cross-section of a copper sintered body in a bonded body produced using a metal paste for bonding obtained in Example 1.
FIG. 4 is SEM images showing a bonding cross-section of a copper sintered body in a bonded body produced using a metal paste for bonding obtained in Comparative Example 7.

### Description of Embodiments

An embodiment for carrying out the present invention (hereinafter, referred to as "present embodiment") will be described in detail below. The present invention is not intended to be limited to the following embodiment.

### <Metal paste for bonding>

The metal paste for bonding of the present embodiment includes metal particles, a dispersion medium, a reducing agent, and a reduction aid, in which the metal particles contain copper particles, the reducing agent contains a polyol-based compound, and the reduction aid contains a coordinating compound having electron back-donation properties.

With regard to the metal paste for bonding of the present embodiment, the coordinating compound is at least one selected from the group consisting of an organic phosphorus compound and an organic sulfur compound, and the metal paste for bonding can contain, as the reducing agent, 1.6 parts by mass or more and 10 parts by mass or less of a polyol-based compound with respect to 100 parts by mass of the total mass of the copper particles. According to such a metal paste for bonding, a bonded body having sufficient bonding strength, in which even in a case where members are bonded under no added pressure conditions in an atmosphere that does not include hydrogen or has a low hydrogen concentration, it is easy to proceed with sintering (generating metallic bonds) while removing oxide films on the copper particles and an adherend to maintain metal surfaces, can be obtained. The inventors of the present invention speculate as follows about the reason why such an effect is obtained. A copper complex to which a coordinating compound is bonded by back-donation bonding tends to be stabilized in a state with a low oxidation number, and this is considered as one of the factors that allow the reduction of copper in an oxidized state to copper metal even in the presence of a polyol-based compound having a low reducing power, and allow the formation of a sintered body having sufficient bonding strength.

### [Copper particles]

As the copper particles, copper sub-microparticles and copper microparticles may be mentioned. Incidentally, the term copper particles refers to particles containing copper as a main component and refers to particles in which, for example, the content proportion of copper in the particles is 80% by mass or more. The content proportion of copper in the copper particles may be 85% by mass or more, 90% by mass or more, 95% by mass or more, 99% by mass or more, or 100% by mass.

### (Copper sub-microparticles)

The copper sub-microparticles may be copper particles having sinterability in a temperature range of 250°C or higher and 380°C or lower. Examples of the copper sub-microparticles include those including copper particles having a particle size of 0.01 µm or more and 0.8 µm or less, and for example, copper particles having a volume average particle size of 0.01 µm or more and 0.8 µm or less can be used. When the volume average particle size of the copper sub-microparticles is 0.01 µm or more, effects such as suppression of the synthesis cost of the copper sub-microparticles, satisfactory dispersibility, and suppression of the amount of an organic protective agent used, are easily obtained. When the volume average particle size of the copper sub-microparticles is 0.8 µm or less, an effect that the copper sub-microparticles have excellent sinterability is likely to be obtained. From the viewpoint of providing the above-described effects more effectively, the volume average particle size of the copper sub-microparticles may be 0.6 µm or less, may be 0.5 µm or less, or may be 0.4 µm or less. Furthermore, the volume average particle size of the copper sub-microparticles may be 0.02 µm or more, may be 0.05 µm or more, or may be 0.1 µm or more. The volume average particle size of the copper sub-microparticles may be, for example, 0.01 µm or more and 0.5 µm or less, may be 0.12 µm or more and 0.8 µm or less, may be 0.15 µm or more and 0.8 µm or less, may be 0.15 µm or more and 0.6 µm or less, may be 0.2 µm or more and 0.5 µm or less, or may be 0.3 µm or more and 0.45 µm or less.

The volume average particle size according to the present specification means 50% volume average particle size. In the case of determining the volume average particle size of the copper particles, the volume average particle size can be determined by a method of measuring a dispersion in which the copper particles that serve as a raw material, or dry copper particles obtained by removing a volatile component from the metal paste for bonding are dispersed in a dispersion medium by using a dispersant, by using a light scattering particle size distribution analyzer (for example, Shimadzu Nanoparticle Size Distribution Analyzer (SALD-7500nano, manufactured by SHIMADZU CORPORATION)), or the like. In the case of using a light scattering particle size distribution analyzer, hexane, toluene, α-terpineol, 4-methyl-1,3-dioxolan-2-one, water, or the like can be used as the dispersion medium.

The content of the copper sub-microparticles may be 20% by mass or more, may be 30% by mass or more, may be 35% by mass or more, may be 40% by mass or more, may be 90% by mass or less, may be 85% by mass or less, may be 80% by mass or less, may be 20% by mass or more and 90% by mass or less, may be 30% by mass or more and 90% by mass or less, may be 35% by mass or more and 85% by mass or less, or may be 40% by mass or more and 80% by mass or less, all based on the total mass of the metal particles. When the content of the copper sub-microparticles is within the above-described range, it is easy to secure the bonding strength of a bonded body manufactured by sintering the copper paste for bonding, and in a case where the copper paste for bonding is used for the bonding of semiconductor elements, the semiconductor device tends to exhibit satisfactory die shear strength and connection reliability.

It is preferable that the content of the copper sub-microparticles is 20% by mass or more and 90% by mass or less based on the sum of all the masses of the copper particles. When the content of the copper sub-microparticles is 20% by mass or more, in a case where the copper sub-microparticles are used in combination with copper microparticles such as flake-shaped copper microparticles, the spaces between the copper particles can be sufficiently filled, it is easy to secure the bonding strength of a bonded boy manufactured by sintering the copper paste for bonding, and in a case where the copper paste for bonding is used for the bonding of semiconductor elements, the semiconductor device tends to exhibit satisfactory die shear strength and connection reliability. When the content of the copper sub-microparticles is 90% by mass or less, since the volume shrinkage at the time of sintering the copper paste for bonding under no added pressure conditions can be sufficiently suppressed, it is easy to secure the bonding strength of a bonded body manufactured by sintering the copper paste for bonding, and in a case where the copper paste for bonding is used for the bonding of semiconductor elements, the semiconductor device tends to exhibit satisfactory die shear strength and connection reliability. From the viewpoint of providing the above-described effects more effectively, the content of the copper sub-microparticles may be 30% by mass or more, may be 35% by mass or more, may be 40% by mass or more, may be 85% by mass or less, may be 83% by mass or less, may be 80% by mass or less, may be 30% by mass or more and 85% by mass or less, may be 35% by mass or more and 85% by mass or less, or may be 40% by mass or more and 80% by mass or less, all based on the total mass of the copper particles.

The shape of the copper sub-microparticles is not particularly limited. Examples of the shape of the copper sub-microparticles include a spherical shape, a lump-like shape, a needle-like shape, a flake shape, an approximately spherical shape, and aggregates of these. From the viewpoints of dispersibility and packing properties, the shape of the copper sub-microparticles may be a spherical shape, an approximately spherical shape, or a flaky shape, and from the viewpoints of combustibility, dispersibility, mixability with flake-shaped microparticles, and the like, the shape may be a spherical shape or an approximately spherical shape. In the present specification, the term "flake shape" includes a flat plate-like shape such as a plate shape or a scale-like shape.

With regard to the copper sub-microparticles, from the viewpoints of dispersibility, packing properties, and mixability with flake-shaped microparticles, the aspect ratio may be 5 or less, may be 4 or less, or may be 3 or less. In the present specification, the "aspect ratio" represents the long side (major axis) / thickness of a particle. Measurement of the long side (major axis) and thickness of a particle can be determined from, for example, a SEM image of the particle.

The copper sub-microparticles may be treated with a surface treatment agent. Examples of the surface treatment agent include organic acids having 2 to 18 carbon atoms. Examples of the organic acids having 2 to 18 carbon atoms include saturated fatty acids such as acetic acid, propanoic acid, butanoic acid, pentanoic acid, hexanoic acid, heptanoic acid, caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, heptadecanoic acid, octadecanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecanoic acid, hexadecenoic acid, palmitoleic acid, sapienic acid, oleic acid, vaccenic acid, linolic acid, linoleic acid, and linolenic acid; and aromatic carboxylic acids such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. Regarding the organic acids, one kind thereof may be used alone, or two or more kinds thereof may be used in combination. When such an organic acid and the above-described copper sub-microparticles are combined, there is a tendency that both the dispersibility of the copper sub-microparticles and the eliminability of the organic acid during sintering can be achieved.

The throughput rate of the surface treatment agent may be an amount that deposits one molecular layer to three molecular layers on the surface of the copper sub-microparticles. This amount can be calculated from the number of molecular layers (n) deposited on the surface of the copper sub-microparticles, the specific surface area (Aₚ) (unit m²/g) of the copper sub-microparticles, the molecular weight (Mₛ) (unit g/mol) of the surface treatment agent, the minimum coating area (Sₛ) (unit m²/pieces) of the surface treatment agent, and the Avogadro's number (N_{A}) (6.02×10²³ pieces). Specifically, the throughput rate of the surface treatment agent is calculated according to the formula: throughput rate (% by mass) of the surface treatment agent = {(n · Aₚ · Mₛ) / (Sₛ · N_{A} + n · Aₚ · Mₛ)} × 100%.

The specific surface area of the copper sub-microparticles can be calculated by measuring dried copper sub-microparticles by a BET specific surface area measurement method. In a case where the surface treatment agent is a linear saturated fatty acid, the minimum coating area of the surface treatment agent is 2.05×10⁻¹⁹ m²/molecule. In the case of other surface treatment agents, for example, the minimum coating area can be calculated from a molecular model or can be measured by the method described in "Chemistry and Education" (Katsuhiro UEDA, Sumio INAFUKU, Iwao MORI, 40(2), 1992, p.114-117). An example of the method for quantifying a surface treatment agent will be described. The surface treatment agent can be identified by using a thermal elimination gas-gas chromatography mass spectrometer with a dry powder obtained by removing the dispersion medium from the copper paste for bonding, whereby the number of carbon atoms and the molecular weight of the surface treatment agent can be determined. The carbon content proportion of the surface treatment agent can be analyzed by carbon content analysis. Examples of the carbon content analysis method include high-frequency induction heating furnace combustion / infrared absorption method. The amount of the surface treatment agent can be calculated from the number of carbon atoms, molecular weight, and carbon content proportion of the identified surface treatment agent, by the above-described formula.

The throughput rate of the surface treatment agent may be 0.07% by mass or more, may be 0.1% by mass or more, may be 0.2% by mass or more, may be 2.1% by mass or less, may be 1.6% by mass or less, may be 1.1% by mass or less, may be 0.07% by mass or more and 2.1% by mass or less, may be 0.10% by mass or more and 1.6% by mass or less, or may be 0.2% by mass or more and 1.1% by mass or less, all based on the mass of the copper sub-microparticles having the surface treatment agent.

Regarding the copper sub-microparticles, commercially available copper sub-microparticles can be used. Examples of commercially available sub-microparticles include CH-0200 (manufactured by MITSUI MINING & SMELTING CO., LTD., volume average particle size 0.36 µm), CH_0200A-L1 (manufactured by MITSUI MINING & SMELTING CO., LTD., volume average particle size 0.21 µm), HT-14 (manufactured by MITSUI MINING & SMELTING CO., LTD., volume average particle size 0.41 µm), CT-500 (manufactured by MITSUI MINING & SMELTING CO., LTD., volume average particle size 0.72 µm), and Tn-Cu100 (manufactured by TAIYO NIPPON SANSO CORPORATION, volume average particle size 0.12 µm).

Since the copper sub-microparticles have satisfactory sinterability, problems that are observed in bonding materials which mainly use copper nanoparticles, such as highly expensive synthesis cost, unsatisfactory dispersibility, and a decrease in the volume shrinkage after sintering, can be reduced.

### (Copper microparticles)

Regarding the copper microparticles, copper particles having a particle size of 2 µm or more and 50 µm or less can be used, and for example, copper particles having a volume average particle size of 2 µm or more and 50 µm or less can be used. When the volume average particle size of the copper microparticles is within the above-described range, volume shrinkage at the time of sintering the copper paste for bonding under no added pressure conditions, generation of voids, and the like can be sufficiently reduced, it is easy to secure the bonding strength of a bonded body manufactured by sintering the copper paste for bonding under no added pressure conditions, and in a case where the copper paste for bonding is used for the bonding of semiconductor elements, the semiconductor device tends to exhibit satisfactory die shear strength and connection reliability. From the viewpoint of providing the above-described effects more effectively, the volume average particle size of the copper microparticles may be 2 µm or more, may be 3 µm or more, may be 20 µm or less, may be 15 µm or less, may be 10 µm or less, may be 2 µm or more and 20 µm or less, may be 2 µm or more and 10 µm or less, may be 3 µm or more and 20 µm or less, or may be 3 µm or more and 10 µm or less.

The shape of the copper microparticles is preferably a flake shape. By using flake-shaped copper microparticles, the copper microparticles in the copper paste for bonding are oriented to be approximately parallel to the bonding surface, thereby the volume shrinkage at the time of sintering the copper paste for bonding can be suppressed, and it is easy to secure the bonding strength of a bonded body manufactured by sintering the copper paste for bonding. In a case where the copper paste for bonding is used for the bonding of a semiconductor element, the semiconductor device tends to exhibit satisfactory die shear strength and connection stability. From the viewpoint of providing the above-described effects more effectively, regarding the flake-shaped copper microparticles, the aspect ratio may be 4 or more, may be 6 or more, may be 10 or more, or may be 50 or more.

The content of the copper microparticles may be 10% by mass or more and 90% by mass or less, may be 15% by mass or more and 65% by mass or less, or may be 20% by mass or more and 60% by mass or less, based on the total mass of the copper particles. When the content of the copper microparticles is within the above-described range, it is easy to secure the bonding strength of a bonded body manufactured by sintering the copper paste for bonding, and in a case where the copper paste for bonding is used for the bonding of a semiconductor element, the semiconductor device tends to exhibit satisfactory die shear strength and connection reliability.

With regard to the copper microparticles, the presence or absence of treatment with a surface treatment agent is not particularly limited; however, from the viewpoints of dispersion stability and oxidation resistance, the copper microparticles may be treated with a surface treatment agent. The surface treatment agent may be removed at the time of bonding. Examples of such a surface treatment agent include aliphatic carboxylic acids such as dodecanoic acid, palmitic acid, heptadecanoic acid, stearic acid, arachidic acid, linolic acid, linoleic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohols such as p-phenylphenol; alkylamines such as octylamine, dodecylamine, and stearylamine; aliphatic nitriles such as stearonitrile and decanenitrile; silane coupling agents such as an alkylalkoxysilane; and polymer treatment agents such as polyethylene glycol, polyvinyl alcohol, polyvinylpyrrolidone, and a silicone oligomer. The surface treatment agents may be used singly, or two or more kinds thereof may be used in combination.

The throughput rate of the surface treatment agent may be an amount of one molecular layer or more on the particle surface. The throughput rate of such a surface treatment agent varies depending on the specific surface area of the copper microparticles, the molecular weight of the surface treatment agent, and the minimum coating area of the surface treatment agent. The throughput rate of the surface treatment agent may be 0.001% by mass or more and 2.0% by mass or less, may be 0.4% by mass or more and 2.0% by mass or less, or may be 0.5% by mass or more and 1.7% by mass or less, based on the mass of the copper microparticles having the surface treatment agent. The specific surface area of the copper microparticles, the molecular weight of the surface treatment agent, and the minimum coating area of the surface treatment agent can be calculated by methods similar to those in the case of the above-mentioned copper sub-microparticles.

Regarding the copper microparticles, commercially available ones can be used. Examples of commercially available flake-shaped microparticles include MA-C025KFD (manufactured by MITSUI MINING & SMELTING CO., LTD., volume average particle size 7.5 µm), 3L3N (manufactured by FUKUDA METAL FOIL & POWDER CO., LTD., volume average particle size 6 µm), 2L3N (manufactured by FUKUDA METAL FOIL & POWDER CO., LTD., volume average particle size 9.9 µm), 4L3N (manufactured by FUKUDA METAL FOIL & POWDER CO., LTD., volume average particle size 3 µm), C3 (manufactured by FUKUDA METAL FOIL & POWDER CO., LTD., volume average particle size 37 µm), and 1110F (manufactured by MITSUI MINING & SMELTING CO., LTD., volume average particle size 3.8 µm).

The copper paste for bonding according to the present embodiment can include copper sub-microparticles and copper microparticles. In a case where the copper paste for bonding is prepared only from the above-described copper sub-microparticles, since volume shrinkage due to drying of the dispersion medium and sintering shrinkage occur significantly, the copper paste for bonding is easily peeled off from the adherend surface during sintering of the copper paste for bonding, and it is difficult to obtain sufficient die shear strength and connection reliability for the bonding of a semiconductor element and the like. In a case where the copper paste for bonding is prepared only from the above-described copper microparticles, there is a tendency that the sintering temperature is elevated, and a sintering step at 400°C or higher is required. By using copper sub-microparticles and copper microparticles in combination, volume shrinkage at the time of sintering the copper paste for bonding under no added pressure conditions is suppressed, and the bonded body can have sufficient bonding strength. In a case where the copper paste for bonding under no added pressure conditions is used for the bonding of a semiconductor element, an effect that the semiconductor device exhibits satisfactory die shear strength and connection reliability is obtained.

From the above-described viewpoints, the copper paste for bonding according to the present embodiment may include copper sub-microparticles having a volume average particle size of 0.15 µm or more and 0.8 µm or less and copper microparticles having a volume average particle size of 2 µm or more and 50 µm or less as copper particles, the sum of the content of copper sub-microparticles and the content of the copper microparticles may be 80% by mass or more based on the total mass of the metal particles, and the content of the copper sub-microparticles may be 30% by mass or more and 90% by mass or less based on the sum of the mass of the copper sub-microparticles and the mass of the copper microparticles.

### (Metal particles other than copper particles)

The metal paste for bonding of the present embodiment may include metal particles including a metal element other than copper (other metal particles) as the metal particles. The other metal particles may include, for example, particles of zinc, gold, palladium, silver, nickel, platinum, brass, manganese, tin, antimony, indium, aluminum, and vanadium. With regard to the other metal particles, the volume average particle size may be 0.01 µm or more and 10 µm or less, may be 0.01 µm or more and 5 µm or less, or may be 0.05 µm or more and 3 µm or less.

In a case where the copper paste for bonding includes other metal particles, since a sintered body in which a plurality of kinds of metals are solid-solutionized or dispersed can be obtained, mechanical characteristics such as the yield stress and fatigue strength of the sintered body are likely to be ameliorated, and the connection reliability is likely to be improved. In addition, by adding a plurality of kinds of metal particles, the sintered body of the copper paste for bonding can have sufficient bonding strength to a specific adherend. In a case where the copper paste for bonding is used for the bonding of a semiconductor element, the die shear strength and connection reliability of the semiconductor device are likely to be improved.

In a case where the copper paste for bonding includes other metal particles, from the viewpoint of obtaining sufficient bonding properties, the content of the other metal particles may be less than 5% by mass, or may be 3% by mass or less, based on the total mass of the metal particles. The other metal particles do not have to be included. The shape of the other metal particles is not particularly limited.

In the metal paste for bonding of the present embodiment, the content of inorganic particles other than metal particles may be 30% by mass or less, may be 20% by mass or less, or may be 0% by mass, based on the total amount of the metal paste for bonding.

### [Reducing agent]

The metal paste for bonding of the present embodiment contains a polyol-based compound as a reducing agent. The polyol-based compound may be a compound having a plurality of OH groups.

Examples of the polyol-based compound include diethylene glycol, triethylene glycol, tetraethylene glycol, pentaethylene glycol, hexaethylene glycol, dipropylene glycol, tripropylene glycol, tetrapropylene glycol, polyethylene glycol, polyethylene glycol 200, polyethylene glycol 300, polyethylene glycol 400, polypropylene glycol, polypropylene glycol 200, polypropylene glycol 300, polypropylene glycol 400, polypropylene glycol 700, polypropylene glycol 4000, polyethylene glycol monooleate, polyethylene glycol monostearate, polyethylene glycol monolaurate, polyoxyethylene sorbitan monolaurate, and polyoxyethylene polyoxypropylene glycol.

The reducing agents can be used singly, or two or more kinds thereof can be used in combination.

With regard to the reducing agent, the 95% weight loss temperature when performing TG-DTA measurement in a nitrogen atmosphere may be 280°C or higher, may be 300°C or higher, or may be 320°C or higher. A sufficient amount of such a reducing agent is likely to be secured in the system during the period from reduction to sintering of the copper particles. Regarding the reducing agent, the 95% weight loss temperature may be 420°C or lower, 400°C or lower, or 380°C or lower. Such a reducing agent is less likely to remain after sintering, and as a result, the sintered body can have characteristics such as, for example, having a sufficient degree of sintering and being less likely to cause corrosion, and is likely to maintain sufficient bonding strength for a long period of time.

From the viewpoint of long-term stability of the bonding strength, the copper paste for bonding can include a polyol-based compound that satisfies the above-mentioned conditions of 95% weight loss temperature.

Examples of the 95% weight loss temperature of the above-mentioned polyol-based compound include polyethylene glycol 200: 322°C, polyethylene glycol 300: 380°C, polyethylene glycol 400: 410°C, polypropylene glycol 300 (triol type): 337°C, polypropylene glycol 400 (diol type): 343°C, polypropylene glycol 700 (diol type): 383°C, and polypropylene glycol 4000 (triol type): 390°C.

From the viewpoint of suppressing sintering failure and securing bonding strength, the content of the reducing agent in the copper paste for bonding may be 1.6 parts by mass or more, 1.8 parts by mass or more, 2.0 parts by mass or more, or 4.0 parts by mass or more, with respect to 100 parts by mass of the total mass of the copper particles, and from the viewpoint of suppressing a decrease in the bonding strength due to an excess of a reduction aid, the content of the reducing agent may be 10 parts by mass or less, 9.0 parts by mass or less, or 8.5 parts by mass or less. From the above-described viewpoints, the content of the reducing agent in the copper paste for bonding may be 1.6 parts by mass or more and 10 parts by mass or less, 1.8 parts by mass or more and 9.0 parts by mass or less, 2.0 parts by mass or more and 8.5 parts by mass or less, or 4.0 parts by mass or more and 8.5 parts by mass or less, with respect to 100 parts by mass of the total mass of the copper particles.

Furthermore, in a case where the copper paste for bonding includes copper particles and other metal particles, the content of the reducing agent may be in the above-mentioned range with respect to 100 parts by mass of the total mass of the metal particles. Examples of the other metal particles include particles of zinc, gold, palladium, silver, nickel, platinum, brass, manganese, tin, antimony, indium, aluminum, and vanadium.

### [Reduction aid]

As the reduction aid, a coordinating compound that can form a copper complex can be used, and examples thereof include a coordinating compound having electron back-donation properties. The coordinating compound may be a compound having both a lone pair of electrons and a vacant π-electron orbital. Such a compound can form a bond with a copper metal atom by using a lone pair of electrons, and a vacant π-orbital and a d-orbital electron of copper can further form a back-donation bond.

As the coordinating compound, at least one selected from the group consisting of an organic phosphorus compound and an organic sulfur compound can be used.

The organic phosphorus compound may be at least one selected from the group consisting of an organic phosphorus compound represented by the following General Formula (1) and an organic phosphorus compound represented by the following General Formula (2). 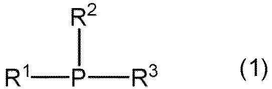 [In which in Formula (1), R¹, R², and R³ each independently represent a monovalent organic group or -OR (R represents a monovalent organic group); and R¹, R², and R³ may form a ring.] 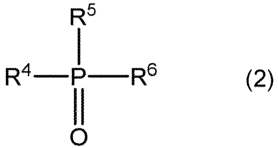 [In which in Formula (2), R⁴, R⁵, and R⁶ each independently represent a monovalent organic group or -OR (R represents a monovalent organic group); and one or more of R⁴, R⁵, and R⁶ are -OR (R represents a monovalent organic group).]

Examples of the organic phosphorus compound represented by the above-described General Formula (1) include trimethylphosphine, tributylphosphine, triphenylphosphine, dimethylphenylphosphine, diethylphenylphosphine, diphenyl-methylphosphine, tri(1-naphthyl)phosphine (tri-1-naphthylphosphine), tris(4-trifluoromethylphenyl)phosphine, and tris[3,5-bis(trifluoromethyl)phenyl]phosphine.

In addition, examples of the organic phosphorus compound represented by the General Formula (1) include phosphoric acid esters such as triisopropyl phosphate, diisopropyl chlorophosphate, tributyl phosphate, di-tert-butyl phosphite ester, trimethyl phosphate, triethyl phosphate, tris(2-butoxyethyl) phosphate, tris(2-ethylhexyl) phosphate, tris(2-chloroethyl) phosphate, triphenyl phosphate, and tripropyl phosphate.

Furthermore, examples of the organic phosphorus compound represented by the General Formula (1) in which R¹, R², and R³ form a ring, include 2,8,9-trimethyl-2,5,8,9-tetraaza-1-phosphabicyclo[3.3.3]undecane, 2,8,9-triisopropyl-2,5,8,9-tetraaza-1-phosphabicyclo[3.3.3]undecane, and 2,8,9-triisobutyl-2,5,8,9-tetraaza-1-phosphabicyclo[3.3.3]undecane.

Examples of the organic phosphorus compound represented by the above-described General Formula (2) include phosphinic acid esters such as triphenyl phosphite, tris(1,1,1,3,3,3-hexafluoro-2-propyl) phosphite, trimethyl phosphite, triethyl phosphite, tripropyl phosphite, triisopropyl phosphite, tributyl phosphite, tris(2-ethylhexyl) phosphite, tris(trimethylsilyl) phosphite, tristearyl phosphite (trioctadecyl phosphite), dimethyl phenylphosphonite, 2-methoxy-2-oxo-1,3,2-dioxaphosphorane, phenyldimethoxyphosphine, ethyl diphenylphosphinite, butyl diphenylphosphinite (diphenylbutoxyphosphine), and diphenylphosphinic acid phenethyl ester.

The organic phosphorus compound may be an organic phosphorus compound represented by the following General Formula (3). 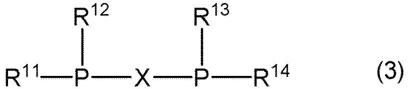 [In which in Formula (3), R¹¹, R¹², R¹³, and R¹⁴ each independently represent an organic group; R¹¹ and R¹² may form a ring; R¹³ and R¹⁴ may form a ring; and X represents a divalent organic group.]

Examples of the organic phosphorus compound represented by the General Formula (3) include 1,2-bis(dicyclohexylphosphino)ethane, ethylene bis(diphenylphosphine), 1,2-bis(dimethylphosphino)ethane, 1,2-bis[2,5-dimethylphosphorano]ethane, 1,2-bis(2,5-diphenylphosphorano)ethane, 1,2-bis[2,5-diisopropylphosphorano] ethane, 1,2-bis(di-tert-butylphosphinomethyl)benzene, 1,2-bis(diphenylphosphino)benzene, 1,3-bis(diphenylphosphino)propane, (oxydi-2,1-phenylene)bis(diphenylphosphine), and 4,5-bis(diphenylphosphino)-9,9-dimethylxanthene.

From the viewpoint of having affinity with an organic dispersion medium and suppressing ionic impurities, a phosphorous acid ester represented by (R⁷O-)₃P (in the formula, R⁷ represents a monovalent organic group), such as a trialkyl phosphite or a triaryl phosphite; an organic phosphorus compound represented by (R⁸-)₃P (in the formula, R⁸ represents a monovalent organic group), such as a trialkylphosphine or a triarylphosphine; or a phosphoric acid ester represented by (R⁹O-)₃P=O (in the formula, R⁹ represents a monovalent organic group), such as a trialkyl phosphate or a triaryl phosphate, can be used.

In addition, from the viewpoint of the affinity with an organic solvent and organic protective particles, the organic phosphorus compound may have an organic substituent such as an aromatic group such as a phenyl group or a naphthyl group; an alkyl group such as an ethyl group, a propyl group, an isopropyl group, a butyl group, a hexyl group, a stearyl group, or a cyclohexyl group; or a polyether group such as a polyethylene oxide group. Furthermore, in a case where the organic phosphorus compound is a phosphoric acid-based compound, from the viewpoint of aggregation resistance against ionic substances, all of P-OH groups may be esterified.

Examples of the organic sulfur compound include thioether and 1,2-dithioketone.

The reduction aids can be used singly, or two or more kinds thereof can be used in combination.

From the viewpoint of suppressing sintering failure and securing bonding strength, the content of the reduction aid in the copper paste for bonding may be 0.5 parts by mass or more, 0.6 parts by mass or more, 0.7 parts by mass or more, or 0.8 parts by mass or more, with respect to 100 parts by mass of the total mass of the copper particles, and from the viewpoint of suppressing a decrease in the bonding strength due to an excess of a reduction aid, the content may be 10 parts by mass or less, 9.0 parts by mass or less, or 7.7 parts by mass or less. In a case where the reduction aid is an organic phosphorus compound represented by the General Formula (1) in which R¹, R², and R³ form a ring, the content of the reduction aid may be 0.05 parts by mass or more and 1 part by mass or less, 0.1 parts by mass or more and 0.5 parts by mass or less, or 0.1 parts by mass or more and 0.4 parts by mass or less, with respect to 100 parts by mass of the total mass of the copper particles.

In addition, in a case where the copper paste for bonding includes copper particles and other metal particles, the content of the reduction aid may be in the above-mentioned range with respect to 100 parts by mass of the total mass of the metal particles. Examples of the other metal particles include particles of zinc, gold, palladium, silver, nickel, platinum, brass, manganese, tin, antimony, indium, aluminum, and vanadium.

### [Dispersion medium]

Examples of the dispersion medium include monohydric and polyhydric alcohols such as pentanol, hexanol, heptanol, octanol, decanol, dihydroterpineol, terpineol, and isobornyl cyclohexanol (MTPH); ethers such as ethylene glycol butyl ether, ethylene glycol phenyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as ethylene glycol ethyl ether acetate, ethylene glycol butyl ether acetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexanone, octane, nonane, decane, and undecane; aromatic hydrocarbons such as benzene, toluene, and xylene; mercaptans having an alkyl group having 1 to 18 carbon atoms; and mercaptans having a cycloalkyl group having 5 to 7 carbon atoms. Examples of the mercaptans having an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans having a cycloalkyl group having 5 to 7 carbon atoms include cyclopentyl mercaptan, cyclohexyl mercaptan, and cycloheptyl mercaptan.

From the viewpoint of printing life (on-plate life), the dispersion medium may be a solvent having a boiling point of 200°C or higher. In addition, the boiling point of the solvent may be 400°C or lower, from the viewpoint that the solvent needs to be removed after sintering.

Regarding the dispersion medium, one kind thereof can be used alone, or two or more kinds thereof can be used in combination.

### [Additives]

The metal paste for bonding may further include additives such as a dispersant, a surface protective agent, a thickener, and a thixotropic agent, as necessary.

In a case where the metal paste for bonding includes additives, from the viewpoint of suppressing a decrease in the sinterability of the metal paste for bonding, the content of additives that are non-volatile or non-degradable at a temperature of 200°C or lower may be 20% by mass or less, may be 5% by mass or less, or may be 1% by mass or less, based on the total amount of the metal paste for bonding.

### <Method for preparing metal paste for bonding>

The metal paste for bonding of the present embodiment can be prepared by mixing the above-mentioned copper particles (for example, copper sub-microparticles and copper microparticles), a reducing agent, a reduction aid, a dispersion medium, as well as other metal particles and optional additives as necessary. After mixing each component, a stirring treatment may be performed. For the metal paste for bonding, the maximum particle size of a dispersion liquid may be adjusted by a classification operation.

The metal paste for bonding may be prepared by mixing copper sub-microparticles, an organic protective agent, and a dispersion medium in advance, performing a dispersion treatment to prepare a dispersion liquid of the copper sub-microparticles, and further mixing the remaining components. By following such a procedure, the dispersibility of the copper sub-microparticles is improved, the mixability with copper microparticles (for example, flake-shaped copper microparticles) is improved, and the performance of the copper paste for bonding can be further improved. In addition, aggregates may be removed from the dispersion liquid of the copper sub-microparticles by a classification operation. The copper sub-microparticles and the organic protective agent may be the copper sub-microparticles treated with the organic protective agent.

The stirring treatment can be performed by using a stirrer. Examples of the stirrer include an Ishikawa-type stirrer, a Silverson stirrer, a cavitation stirrer, a rotation-revolution type stirring apparatus, an ultrathin film high-speed rotary disperser, an ultrasonic disperser, a Raikai machine, a twin-screw kneader, a bead mill, a ball mill, and a three-roll mill, a Homomixer, a Planetary mixer, an ultra-high pressure type disperser, a thin layer shear disperser, and a Disperizer.

Examples of the dispersion treatment include a thin layer shear disperser, a Disperizer, a bead mill, an ultrasonic homogenizer, a high-shear mixer, a narrow-gap three-roll mill, a wet type ultra-atomizer, an supersonic jet mill, and an ultra-high pressure homogenizer.

The classification operation can be carried out by, for example, using filtration, natural sedimentation, or centrifugal separation. Examples of a filter for filtration include a water comb, a metal mesh, a metal filter, and a nylon mesh.

The copper paste for bonding may have a viscosity adjusted to be appropriate for printing and coating techniques. Regarding the viscosity of the copper paste for bonding, for example, the Casson viscosity at 25°C may be 0.05 Pa·s or higher and 2.0 Pa·s or lower, or may be 0.06 Pa·s or higher and 1.0 Pa·s or lower.

### <Method for manufacturing bonded body>

A method for manufacturing a bonded body according to the present embodiment includes: a laminated body preparation step of preparing a laminated body in which a first member, the above-mentioned metal paste for bonding according to the present embodiment, and a second member are laminated in this order; and a sintering step of sintering the metal paste for bonding in the laminated body.

### (Laminated body preparation step)

Examples of the first member and the second member include semiconductor elements such as an IGBT, a diode, a Schottky barrier diode, a MOS-FET, a thyristor, a logic, a sensor, an analog integrated circuit, an LED, a semiconductor laser, and a transmitter; base materials for mounting semiconductor elements, such as a lead frame, a metal plate-attached ceramic substrate (for example, a DBC), and an LED package; power supply members such as a copper ribbon, a metal block, and a terminal; a heat sink, and a water-cooling plate.

The first member and the second member may have a metal layer that forms metallic bonds with a sintered body of the metal paste for bonding, on the bonding surface. Examples of the metal constituting the metal layer include copper, nickel, silver, gold, palladium, platinum, lead, tin, and cobalt. These metals may be used singly, or two or more kinds thereof may be used in combination. In addition, the metal layer may be an alloy including the above-described metals. Examples of the metals used for the alloy include zinc, manganese, aluminum, beryllium, titanium, chromium, iron, and molybdenum, in addition to the above-described metals. Examples of a member having a metal layer include various members having metal plating, a wire, a chip having metal plating, a heat spreader, a ceramic substrate having a metal plate attached thereto, various lead frames having metal plating or lead frames formed from various metals, a copper plate, and a copper foil.

The laminated body can be prepared by, for example, providing the metal paste for bonding of the present embodiment on necessary portions of the above-mentioned second member, and then disposing the above-mentioned first member on the metal paste for bonding. In this case, a laminated body in which on the first member, the metal paste for bonding and the second member are laminated in this order on the side of a direction in which the weight of the first member acts, can be prepared, and the metal paste for bonding of this laminated body can be sintered under no added pressure conditions, that is, in a state in which the metal paste for bonding is subjected only to the weight of the first member, or only to the weight of the first member and the weight of a weight used for the purpose of prevention of chip tilting, void reduction, and the like. The weight of the weight may be 0.01 MPa or less when calculated in terms of pressure. Incidentally, the direction in which the weight of the first member acts can also be referred to as a direction in which gravity acts.

Regarding the weight, a metal weight having a size comparable to the size of the chip and having a thickness of 20 mm or less may be mentioned. As the metal weight, a weight made of SUS having a thickness of 5 mm or less, or the like can be used.

The method for providing the metal paste for bonding of the present embodiment on a necessary portion of the second member, may be a method of allowing the copper paste for bonding to be deposited thereon. Regarding such a method, inkjet printing, super inkjet printing, screen printing, transfer printing, offset printing, a jet printing method, a dispenser, a jet dispenser, a needle dispenser, a comma coater, a slit coater, a die coater, a gravure coater, slit coating, letterpress printing, intaglio printing, gravure printing, stencil printing, soft lithography, bar coating, an applicator, a particle deposition method, a spray coater, a spin coater, a dip coater, electrodeposition coating, and the like can be used.

The thickness of the metal paste for bonding may be 1 µm or more, may be 5 µm or more, may be 10 µm or more, or may be 20 µm or more. Furthermore, the thickness of the metal paste for bonding may be 3000 µm or less, may be 1000 µm or less, may be 500 µm or less, may be 300 µm or less, may be 250 µm or less, may be 200 µm or less, or may be 150 µm or less.

The applied metal paste for bonding may be dried as appropriate from the viewpoint of suppressing flow during sintering and the generation of voids. The gas atmosphere during drying may be an air atmosphere, may be an oxygen-free atmosphere such as nitrogen or a noble gas, or may be a reducing atmosphere such as hydrogen or formic acid. Regarding the drying method, the metal paste for bonding may be dried by leaving to stand at normal temperature, may be dried by heating, or may be dried under reduced pressure.

With regard to drying by heating or drying under reduced pressure, for example, a hot plate, a hot air dryer, a hot air heating furnace, a nitrogen dryer, an infrared dryer, an infrared heating furnace, a far-infrared heating furnace, a microwave heating apparatus, a laser heating apparatus, an electromagnetic heating apparatus, a heater heating apparatus, a steam heating furnace, and a hot plate press apparatus can be used. The temperature and time for drying may be adjusted as appropriate in accordance with the type and amount of the dispersion medium used. Regarding the temperature and time for drying, it is desirable to perform drying at 50°C or higher and 150°C or lower in air or in an oxygen-free atmosphere.

Examples of a method for disposing the first member on the metal paste for bonding include a chip mounter, a flip chip bonder, and a positioning tool made of carbon or ceramic.

### (Sintering step)

In the sintering step, sintering of the copper paste for bonding can be carried out by performing a heating treatment under no added pressure conditions in an oxygen-free atmosphere. The oxygen-free atmosphere may be an atmosphere that does not include hydrogen or has a hydrogen concentration of 10% or less. The oxygen-free atmosphere refers to an atmosphere having an oxygen concentration of 1% by volume or less, and the oxygen concentration may be 0.1% by volume or less, 0.01% by volume or less, or 0.001% by volume or less.

For the heating treatment, a heating apparatus without a pressure-bonding mechanism can be used. Examples of the heating apparatus include a hot plate, a hot air dryer, a hot air heating furnace, a nitrogen dryer, an infrared dryer, an infrared heating furnace, a far-infrared heating furnace, a microwave heating apparatus, a laser heating apparatus, an electromagnetic heating apparatus, a heater heating apparatus, and a steam heating furnace.

Regarding the atmosphere that does not include hydrogen, an atmosphere in a non-oxidizing gas such as nitrogen, a noble gas, a heat-resistant organic gas, water vapor, or a mixed gas of these, or under vacuum may be mentioned.

The gas atmosphere during sintering may be a reducing atmosphere. Examples of the reducing atmosphere include nitrogen including formic acid gas, a noble gas including formic acid gas, and a non-oxidizing gas including 10% or less of hydrogen. In addition, the gas atmosphere during sintering may be a forming gas (nitrogen including hydrogen at or below the lower explosion limit (for example, 5% or less or 3% or less)), or a low-molecular weight alcohol (for example, methanol or ethanol) vapor.

From the viewpoint of reducing thermal damage to the members to be bonded and improving the product yield, the maximum reached temperature during the heating treatment may be 200°C or higher and 450°C or lower, may be 250°C or higher and 400°C or lower, may be 250°C or higher and 350°C or lower, or may be 250°C or higher and 300°C or lower.

From the viewpoint of volatilizing all the dispersion medium and improving the product yield, the retention time at the maximum reached temperature may be 1 minute or longer and 60 minutes or shorter, may be 1 minute or longer and shorter than 40 minutes, or may be 1 minute or longer and shorter than 30 minutes. Particularly, when the maximum reached temperature is 250°C or higher, it is easy to proceed with sintering sufficiently in a retention time of 60 minutes or shorter.

### <Bonded body and semiconductor device>

Hereinafter, suitable embodiments will be described in detail with reference to the drawings. Identical or corresponding portions in the figure will be assigned with identical reference numerals, and any redundant description will not be repeated. Furthermore, the dimensional ratio of a figure is not limited to the ratio shown in the figure.

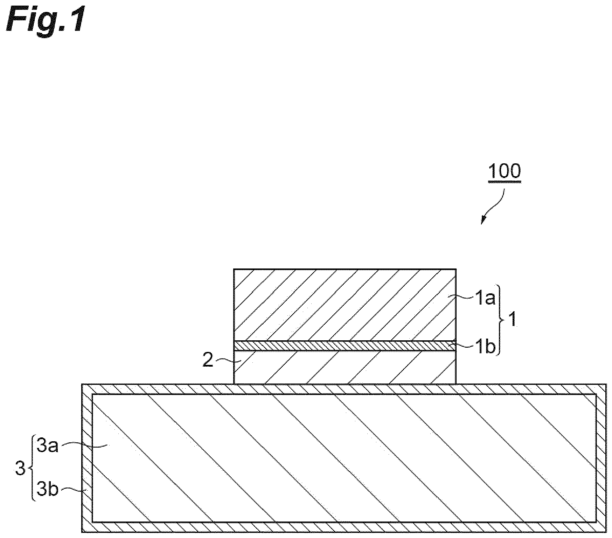

FIG. 1 is a schematic cross-sectional view illustrating an example of a bonded body manufactured by using a metal paste for bonding. The bonded body 100 of the present embodiment includes: a first member 1 having a first base part 1a and a first metal layer 1b; a second member 3 having a second base part 3a and a second metal layer 3b; and a sintered body 2 bonding the first member 1 and the second member 3.

As the first member 1 and the second member 3, the above-mentioned ones may be mentioned. Furthermore, with regard to the first metal layer 1b and the second metal layer 3b as well, the above-mentioned ones may be mentioned.

The sintered body 2 may be a sintered body of the metal paste for bonding according to the present embodiment. In this case, the bonded body 100 can be obtained by the above-described method for manufacturing a bonded body according to the present embodiment.

From the viewpoint of sufficiently bonding the first member and the second member, the die shear strength of the bonded body may be 10 MPa or greater, may be 15 MPa or greater, may be 20 MPa or greater, or may be 30 MPa or greater. The die shear strength can be measured by using a universal-type bond tester (4000 Series, manufactured by DAGE) or the like.

From the viewpoint of heat dissipation properties and connection reliability at high temperatures, the thermal conductivity of the sintered body may be 100 W/(m·K) or higher, may be 120 W/(m·K) or higher, or may be 150 W/(m·K) or higher. The thermal conductivity can be calculated from the thermal diffusivity, specific heat capacity, and density of a sintered body of the metal paste for bonding.

With regard to the bonded body, at least one of the first member and the second member may be a semiconductor element. Examples of the semiconductor element include power modules including a diode, a rectifier, a thyristor, an MOS gate driver, a power switch, a power MOSFET, an IGBT, a Schottky barrier diode, a fast recovery diode, and the like; a transmitter, an amplifier, and an LED module. In such a case, the bonded body becomes a semiconductor device. The obtained semiconductor device can have sufficient die shear strength and connection reliability.

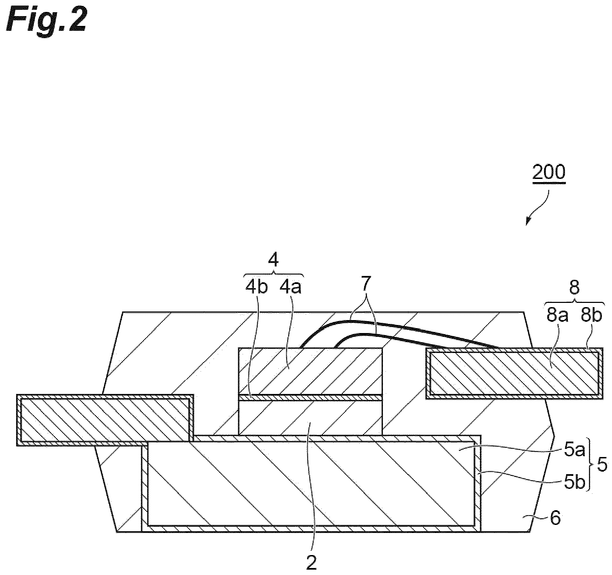

FIG. 2 is a schematic cross-sectional view illustrating an example of a semiconductor device manufactured by using a metal paste for bonding. The semiconductor device 200 shown in FIG. 2 includes, on a lead frame 5 having a metal layer 5b and a base part 5a, a semiconductor element 4 having a metal layer 4b and a base part 4a, which are connected to the lead frame 5 through a sintered body 2 of the copper paste for bonding, and a mold resin 6 molding these. The semiconductor element 4 is connected to a lead frame 8 having a metal layer 8b and a base part 8a through wires 7.

Examples of the semiconductor device include power modules including a diode, a rectifier, a thyristor, a MOS gate driver, a power switch, a power MOSFET, an IGBT, a Schottky barrier diode, a fast recovery diode, and the like; a transmitter, an amplifier, a high-brightness LED module, a semiconductor laser module, a logic, and a sensor.

The above-described semiconductor device can be manufactured in the same manner as in the above-mentioned method for manufacturing a bonded body according to the present embodiment. That is, the method for manufacturing a semiconductor device may include a step of preparing a laminated body in which a semiconductor element is used as at least one of a first member and a second member, and a first member, a metal paste for bonding, and a second member are laminated in this order, and sintering the metal paste for bonding in the laminated body by heating the laminated body under no added pressure conditions in an oxygen-free atmosphere. The oxygen-free atmosphere may be an atmosphere that does not include hydrogen or has a hydrogen concentration of 10% or less.

The metal paste for bonding may have a composition similar to that of the metal paste for bonding according to the present embodiment. The preparation of the laminated body and sintering of the metal paste for bonding can also be carried out in the same manner as in the above-mentioned laminated body preparation step and sintering step.

The present disclosure can provide the following inventions according to [1] to [10].
[1] A metal paste for bonding including metal particles, a dispersion medium, a reducing agent, and a reduction aid, in which the metal particles contain copper particles, the reduction aid includes a coordinating compound having electron back-donation properties, the coordinating compound is at least one selected from the group consisting of an organic phosphorus compound and an organic sulfur compound, and the metal paste for bonding contains, as the reducing agent, 1.6 parts by mass or more and 10 parts by mass or less of a polyol-based compound with respect to 100 parts by mass of a total mass of the copper particles.
[2] The metal paste for bonding according to the above-described item [1], in which the coordinating compound has a lone pair of electrons and a vacant π-electron orbital.
[3] The metal paste for bonding according to the above-described item [1], in which the coordinating compound is at least one selected from the group consisting of an organic phosphorus compound represented by the following Formula (1) and an organic phosphorus compound represented by the following Formula (2). 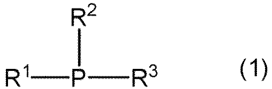 [In which in Formula (1), R¹, R², and R³ each independently represent a monovalent organic group or -OR (R represents a monovalent organic group); and R¹, R², and R³ may form a ring.] 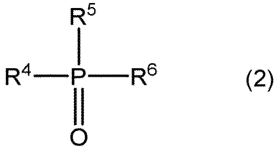 [In which in Formula (2), R⁴, R⁵, and R⁶ each independently represent a monovalent organic group or -OR (R represents a monovalent organic group); and one or more of R⁴, R⁵, and R⁶ are -OR (R represents a monovalent organic group).]
[4] The metal paste for bonding according to any one of the above-described items [1] to [3], in which a content of the reduction aid is 0.5 parts by mass or more and 10 parts by mass or less with respect to 100 parts by mass of the total mass of the copper particles.
[5] The metal paste for bonding according to any one of the above-described items [1] to [4], in which the copper particles include copper sub-microparticles having a volume average particle size of 0.15 µm or more and 0.8 µm or less and copper microparticles having a volume average particle size of 2 µm or more and 50 µm or less, a sum of a content of the copper sub-microparticles and a content of the copper microparticles is 80% by mass or more based on a total mass of the metal particles, and the content of the copper sub-microparticles is 30% by mass or more and 90% by mass or less based on a sum of a mass of the copper sub-microparticles and a mass of the copper microparticles.
[6] The metal paste for bonding according to the above-described item [5], in which the copper microparticles are flake-shaped.
[7] A method for manufacturing a bonded body, the method including:
   a step of preparing a laminated body in which a first member, the metal paste for bonding according to any one of the above-described items [1] to [6], and a second member are laminated in this order; and
   a sintering step of sintering the metal paste for bonding in the laminated body.
[8] The method for manufacturing a bonded body according to the above-described item [7], in which in the sintering step, the metal paste for bonding is sintered under no added pressure conditions in an oxygen-free atmosphere.
[9] The method for manufacturing a bonded body according to the above-described item [7] or [8], in which at least one of the first member and the second member is a semiconductor element.
[10] A bonded body including a first member, a second member, and a sintered body of the metal paste for bonding according to any one of the above-described items [1] to [6], the sintered body bonding the first member and the second member.

### Examples

Hereinafter, the present invention will be described more specifically by way of Examples. However, the present invention is not intended to be limited to the following Examples.

Measurement of each characteristic in each of Examples and Comparative Examples was performed by the following methods.

### (1) Die shear strength

The bonding strength of a bonded body was evaluated by using the die shear strength between a silicon chip and a copper substrate bonded with a metal paste.

A metal paste was applied on a copper plate (19 mm × 25 mm × 3 mm) by stencil printing using a metal mask, in which nine square-shaped openings with a size of 3 mm × 3 mm were provided in a stainless steel plate having a thickness of 200 µm, and a metal squeegee. A silicon chip (area 3 mm × 3 mm, thickness 400 µm, having a copper sputtered layer as an adhered surface (bonding surface) to the metal paste) was placed on the applied metal paste and lightly pressed with tweezers to obtain a laminated body. The laminated body was heated at 90°C for 60 minutes in air using a hot plate (manufactured by AS ONE CORPORATION, EC HOTPLATE EC-1200N). The laminated body was placed in a fluxless reflow apparatus (manufactured by Ayumi INDUSTRY CO., LTD.), the pressure was reduced to 1 Pa to remove air, nitrogen gas was introduced thereto to purge, the laminated body was heated at 300°C for 1 hour while causing nitrogen to flow at a rate of 15 L/min at normal pressure, and a bonded body in which the copper plate and the silicon chip were bonded with a copper sintered body was obtained. This bonded body was cooled, and when the temperature reached 50°C or lower, the bonded body was taken out into air.

The silicon chip of the obtained bonded body was pressed in a horizontal direction at a measurement speed of 500 µm/s and a measurement height of 100 µm by using a universal type bond tester (4000 Series, manufactured by DAGE) equipped with a load cell of 1 kN, and the die shear strength was measured. The average value of the values obtained by measuring eight bonded bodies was designated as the die shear strength.

Incidentally, the die shear strength of bonded bodies in which a silicon chip and a copper substrate were bonded by lead solder was 20 MPa.

### (2) Bonding cross-section of sintered copper

Each of the bonded bodies produced in the above-described section "(1) Die shear strength" was fixed in a cup with a sample clip (Samplklip I, manufactured by Buehler Ltd.), an epoxy casting resin (EPOMOUNT, manufactured by Refine Tec Ltd.) was poured into the surroundings until the entire bonded body was buried, the cup was left to stand in a vacuum desiccator, and the pressure was reduced for 1 minute to defoam. Thereafter, the cup was left to stand at room temperature for 10 hours, the epoxy casting resin was cured, and a sample was prepared. The sample was cut near the silicon chip by using a Refine Saw Excel (manufactured by Refine Tec Ltd.). The bonded body was shaved to the vicinity of the center to obtain a cross-section by using a polishing apparatus (Refine Polisher HV, manufactured by Refine Tec Ltd.) equipped with water-resistant abrasive paper (Carbomac Paper, manufactured by Refine Tec Ltd.). This cross-section was subjected to flat milling processing (Hitachi High-Tech Co., Ltd., IM4000) using Ar ions. The bonding cross-section of the copper sintered body was observed by using a scanning electron microscope (Schottky FE-SEM SU5000, manufactured by Hitachi High-Tech Co., Ltd.).

### [Preparation of metal paste for bonding]

Metal pastes for bonding in the feed amount (parts by mass) shown in Tables 1 to 5 were each prepared according to the procedure described below. The feed amount shown in the tables is the proportion (parts by mass) of each component when the total mass of the copper particles included in the metal paste for bonding was taken as 100 parts by mass (100 parts by mass of the sum total of copper sub-microparticles and copper microparticles). Furthermore, regarding the reduction aid, a reduction aid in a lump-like form or a pellet form was pulverized by using a planetary ball mill and was produced into a fine powder before use.

### (Example A-1)

99 g of dihydroterpineol (manufactured by Nippon Terpene Chemicals, Inc.) as a dispersion medium and 1000 g of CH-0200 (manufactured by MITSUI MINING & SMELTING CO., LTD., product name, laser scattering method 50% volume average particle size 0.36 µm) as copper sub-microparticles were mixed, and the mixture was stirred for 30 minutes at a speed of rotation of 300 rpm by using a planetary mixer (manufactured by PRIMIX Corporation). The obtained mixture was subjected to a dispersion treatment once by using a Disperizer (manufactured by SINTOKOGIO, LTD.) under the conditions of a gap of 50 µm and a speed of rotation of 12000 rpm to obtain a 91% by mass dispersion liquid.

0.169 g of dihydroterpineol (manufactured by Nippon Terpene Chemicals, Inc.) as the remainder of the dispersion medium, 0.240 g of tetraethylene glycol (hereinafter, abbreviated to TEG) (manufactured by FUJIFILM Wako Pure Chemical Corporation) as a reducing agent, 0.300 g of polyethylene glycol 300 (hereinafter, abbreviated to PEG300) (manufactured by FUJIFILM Wako Pure Chemical Corporation) and 0.300 g of polyethylene glycol 400 (hereinafter, abbreviated to PEG400) (manufactured by FUJIFILM Wako Pure Chemical Corporation) as polyol-based compounds, 0.173 g of triphenylphosphine (manufactured by FUJIFILM Wako Pure chemical Corporation) as a reduction aid, 13.538 g of the 91% by mass dispersion liquid obtained as described above, and 5.280 g of 2L3N (manufactured by FUKUDA METAL FOIL & POWDER CO., LTD., product name, laser scattering method 50% volume average particle size 9.9 µm) as copper microparticles were mixed, and the mixture was stirred at 2000 rpm under reduced pressure for 3 minutes by using a rotation-revolution rotary mixer (manufactured by THINKY CORPORATION, Awatori Rentaro ARE-310) to obtain a metal paste for bonding.

### (Example A-2)

A metal paste for bonding was obtained in the same manner as in Example A-1, except that the reduction aid was changed to triisopropyl phosphite (manufactured by Tokyo Chemical Industry Co., Ltd.) instead of triphenylphosphine.

### (Example A-3)

A metal paste for bonding was obtained in the same manner as in Example A-1, except that the reduction aid was changed to triphenyl phosphite (manufactured by FUJIFILM Wako Pure Chemical Corporation) instead of triphenylphosphine.

### (Example A-4 to Example A-7)

Each of metal pastes for bonding was obtained in the same manner as in Example A-1, except that the feed amounts of the copper particles, the dispersion medium, and the reduction aid were changed to the proportions shown in Table 1 (with respect to 100 parts by mass of the total mass of the copper particles, the mass of the reduction aid was 1.23 parts by mass, 0.98 parts by mass, 0.95 parts by mass, or 0.82 parts by mass).

### (Example A-8 to Example A-10)

Each of metal pastes for bonding was obtained in the same manner as in Example A-1, except that the feed amounts of the copper particles, the dispersion medium, and the reducing agent were changed to the proportions shown in Table 2 (with respect to 100 parts by mass of the total mass of the copper particles, the mass of the reduction aid was 4.77 parts by mass, 3.26 parts by mass, or 2.31 parts by mass).

### (Example A-11 to Example A-13)

Each of metal pastes for bonding was obtained in the same manner as in Example A-1, except that the feed amounts of the copper particles and the reducing agent were changed to the proportions shown in Table 2.

### (Example A-14)

Each of metal pastes for bonding was obtained in the same manner as in Example A-1, except that the reducing agent was changed to polypropylene glycol 300 (hereinafter, abbreviated to PPG300) (manufactured by FUJIFILM Wako Pure Chemical Corporation, triol type) and polypropylene glycol 700 (hereinafter, abbreviated to PPG700) (manufactured by FUJIFILM Wako Pure Chemical Corporation, diol type) instead of TEG, PEG300, and PEG400, and the feed amounts of the copper particles and the reducing agent were changed to the proportions shown in Table 2.

### (Example A-15)

A metal paste for bonding was obtained in the same manner as in Example A-1, except that the reduction aid was changed to 2,8,9-triisobutyl-2,5,8,9-tetraaza-1-phosphabicyclo[3.3.3]undecane (manufactured by Sigma-Aldrich Chemistry) instead of triphenylphosphine, and the feed amounts of the dispersion medium, reducing agent, and reduction aid were changed to the proportions shown in Table 3 (with respect to 100 parts by mass of the total mass of the copper particles, the mass of the reduction aid was 0.12 parts by mass).

### (Example A-16)

A metal paste for bonding was obtained in the same manner as in Example A-1, except that the reduction aid was changed to 2,8,9-triisobutyl-2,5,8,9-tetraaza-1-phosphabicyclo[3.3.3]undecane (manufactured by Sigma-Aldrich Chemistry) instead of triphenylphosphine, and the feed amounts of the dispersion medium, reducing agent, and reduction aid were changed to the proportions shown in Table 3 (with respect to 100 parts by mass of the total mass of the copper particles, the mass of the reduction aid was 0.30 parts by mass).

### (Comparative Example A-1 to Comparative Example A-6)

Each of metal pastes for bonding was obtained in the same manner as in Example A-1, except that the reduction aid was changed to dimethylglutaric acid, nitrilotriacetic acid, ascorbic acid, triethanolamine, diethyl tartrate, or glycine as shown in Table 4, instead of triphenylphosphine.

### (Comparative Example A-7)

A metal paste for bonding was obtained in the same manner as in Example A-1, except that a reduction aid was not blended, and the feed amount of the dispersion medium was changed to the proportion shown in Table 4.

### (Comparative Example A-8 to Comparative Example A-10)

Each of metal pastes for bonding was obtained in the same manner as in Example A-1, except that the feed amounts of the copper particles, dispersion medium, and reducing agent were changed to the proportions shown in Table 5 (with respect to 100 parts by mass of the total mass of the copper particles, the mass of the reduction aid was 1.23 parts by mass, 0.98 parts by mass, 0.95 parts by mass, or 0.82 parts by mass).

### [Evaluation of metal pastes for bonding]

Bonded bodies were produced according to the method described in (1) Die shear strength, by using the metal pastes for bonding obtained in Examples and Comparative Examples, and an evaluation of the bonding strength was performed. The results are shown in the tables.

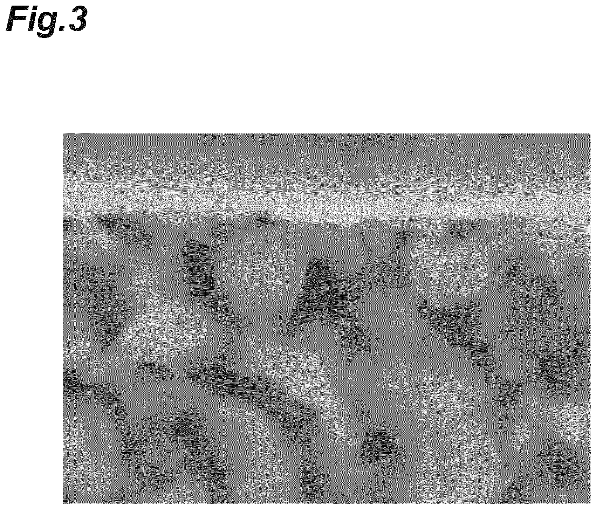

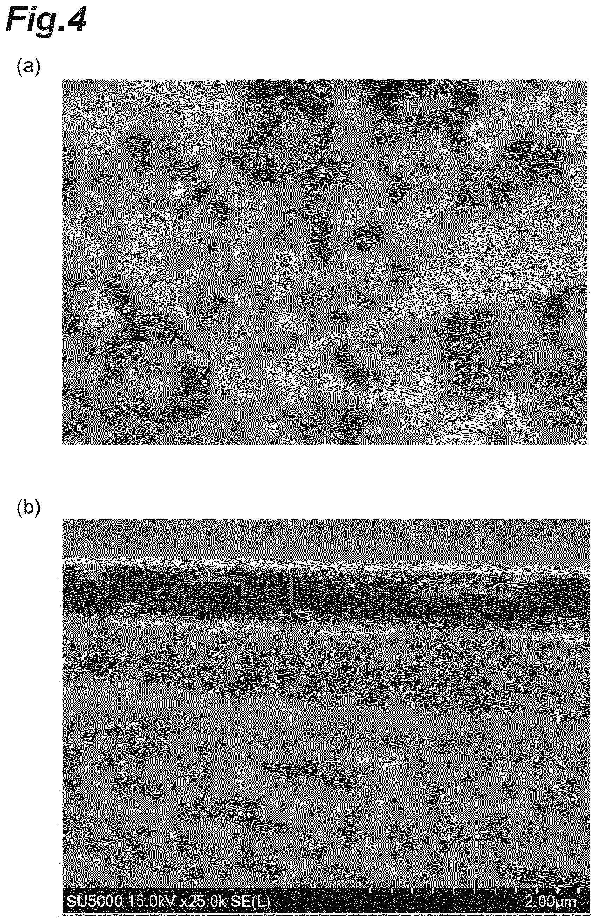

For the produced bonded bodies, a bonding cross-section of the copper sintered body was observed according to the method described in (2) Bonding cross-section of sintered copper. FIG. 3 is a SEM image showing a bonding cross-section of a copper sintered body in a bonded body produced using the metal paste for bonding of Example 1, and FIG. 4 is SEM images showing a bonding cross-section of a copper sintered body in a bonded body produced using a metal paste for bonding obtained in Comparative Example 7. As shown in FIG. 3, in the bonded body obtained by using the metal paste for bonding of Example 1, the copper particles were sintered together to form a network-like structure. In addition, this network structure was also integrated with the surface of an adherend (copper substrate) in the lower part of the photograph, and it was considered that bonding was formed. On the other hand, as shown in FIG. 4(a), in the bonded body obtained by using the metal paste for bonding of Comparative Example 7, the shape of the raw material particles remained as it was, sintering between the particles did not occur, and a network structure was not formed. Therefore, as shown in FIG. 4(b), sites where bonding was not formed were observed at the interface on the chip side.

**[Table 1]**

| | | Example A-1 | Example A-2 | Example A-3 | Example A-4 | Example A-5 | Example A-6 | Example A-7 |
|---|---|---|---|---|---|---|---|---|
| Dispersion medium | Dihydroterpineol | 7.88 | 7.88 | 7.88 | 7.64 | 7.88 | 7.91 | 8.05 |
| Reducing agent | TEG | 1.36 | 1.36 | 1.36 | 1.36 | 1.36 | 1.36 | 1.36 |
| | PEG300 | 1.70 | 1.70 | 1.70 | 1.70 | 1.70 | 1.70 | 1.70 |
| | PEG400 | 1.70 | 1.70 | 1.70 | 1.70 | 1.70 | 1.70 | 1.70 |
| Reduction aid | Triphenylphosphine | 0.98 | - | - | 1.23 | 0.98 | 0.95 | 0.82 |
| | Triisopropyl phosphite | - | 0.98 | - | - | - | - | - |
| | Triphenyl phosphite | - | - | 0.98 | - | - | - | - |
| Copper sub-microparticles | CH-0200 | 70 | 70 | 70 | 69 | 69 | 69 | 69 |
| Copper microparticles | 2L3N | 30 | 30 | 30 | 31 | 31 | 31 | 31 |
| Total mass of copper particles (parts by mass) | | 100 | 100 | 100 | 100 | 100 | 100 | 100 |
| Bonding conditions (in nitrogen atmosphere) | Added pressure (MPa) | 0 | 0 | 0 | 0 | 0 | 0 | 0 |
| | Temperature (°C) | 300 | 300 | 300 | 300 | 300 | 300 | 300 |
| | Time (minutes) | 60 | 60 | 60 | 60 | 60 | 60 | 60 |
| Die shear strength (MPa) | | 51 | 53 | 66 | 40 | 51 | 42 | 37 |

**[Table 2]**

| | | Example A-8 | Example A-9 | Example A-10 | Example A-11 | Example A-12 | Example A-13 | Example A-14 |
|---|---|---|---|---|---|---|---|---|
| Dispersion medium | Dihydroterpineol | 7.88 | 9.38 | 10.34 | 7.88 | 7.88 | 7.88 | 7.88 |
| Reducing agent | TEG | 1.36 | 0.95 | 0.68 | 1.36 | - | 2.05 | - |
| | PEG300 | 2.05 | 1.36 | 0.95 | 3.41 | 2.73 | - | - |
| | PEG400 | 1.36 | 0.95 | 0.68 | - | 2.05 | 2.73 | - |
| | PPG300 | - | - | - | - | - | - | 2.73 |
| | PPG700 | - | - | - | - | - | - | 2.05 |
| Reduction aid | Triphenylphosphine | 0.98 | 0.98 | 0.98 | 0.98 | 0.98 | 0.98 | 0.98 |
| Copper sub-microparticles | CH-0200 | 67 | 67 | 67 | 67 | 67 | 67 | 67 |
| Copper microparticles | 2L3N | 33 | 33 | 33 | 33 | 33 | 33 | 33 |
| Total mass of copper particles (parts by mass) | | 100 | 100 | 100 | 100 | 100 | 100 | 100 |
| Bonding conditions (in nitrogen atmosphere) | Added pressure (MPa) | 0 | 0 | 0 | 0 | 0 | 0 | 0 |
| | Temperature (°C) | 300 | 300 | 300 | 300 | 300 | 300 | 300 |
| | Time (minutes) | 60 | 60 | 60 | 60 | 60 | 60 | 60 |
| Die shear strength (MPa) | | 40 | 42 | 28 | 40 | 38 | 26 | 28 |

**[Table 3]**

| | | Example A-15 | Example A-16 |
|---|---|---|---|
| Dispersion medium | Dihydroterpineol | 7.42 | 7.24 |
| Reducing agent | TEG | 0 | 0 |
| | PEG300 | 2.20 | 2.20 |
| | PEG400 | 2.35 | 2.35 |
| Reduction aid | 2,8,9-Triisobutyl-2,5,8,9-tetraaza-1-phosphabicyclo[3.3.3]undecane | 0.12 | 0.30 |
| Copper sub-microparticles | CH-0200 | 70 | 70 |
| Copper microparticles | 2L3N | 30 | 30 |
| Total mass of copper particles (parts by mass) | | 100 | 100 |
| Bonding conditions (in nitrogen atmosphere) | Added pressure (MPa) | 0 | 0 |
| | Temperature (°C) | 300 | 300 |
| | Time (minutes) | 60 | 60 |
| Die shear strength (MPa) | | 23 | 57 |

**[Table 4]**

| | | Comparative Example A-1 | Comparativ e Example A-2 | Comparative Example A-3 | Comparative Example A-4 | Comparative Example A-5 | Comparative Example A-6 | Comparative Example A-7 |
|---|---|---|---|---|---|---|---|---|
| Dispersion medium | Dihydroterpineol | 7.88 | 7.88 | 7.88 | 7.88 | 7.88 | 7.88 | 8.86 |
| Reducing agent | TEG | 1.36 | 1.36 | 1.36 | 1.36 | 1.36 | 1.36 | 1.36 |
| | PEG300 | 1.70 | 1.70 | 1.70 | 1.70 | 1.70 | 1.70 | 1.70 |
| | PEG400 | 1.70 | 1.70 | 1.70 | 1.70 | 1.70 | 1.70 | 1.70 |
| Reduction aid | Dimethylglutaric acid | 0.98 | - | - | - | - | - | - |
| | Nitrilotriacetic acid | - | 0.98 | - | - | - | - | - |
| | Ascorbic acid | - | - | 0.98 | - | - | - | - |
| | Triethanolamine | - | - | - | 0.98 | - | - | - |
| | Diethyl tartrate | - | - | - | - | 0.98 | - | - |
| | Glycine | - | - | - | - | - | 0.98 | - |
| Copper sub-microparticles | CH-0200 | 70 | 70 | 70 | 70 | 70 | 70 | 70 |
| Copper microparticles | 2L3N | 30 | 30 | 30 | 30 | 30 | 30 | 30 |
| Total mass of copper particles (parts by mass) | | 100 | 100 | 100 | 100 | 100 | 100 | 100 |
| Bonding conditions (in nitrogen atmosphere) | Added pressure (MPa) | 0 | 0 | 0 | 0 | 0 | 0 | 0 |
| | Temperature (°C) | 300 | 300 | 300 | 300 | 300 | 300 | 300 |
| | Time (minutes) | 60 | 60 | 60 | 60 | 60 | 60 | 60 |
| Die shear strength (MPa) | | 17 | 13 | 4 | 2 | 0 | 0 | 0 |

**[Table 5]**

| | | Comparative Example A-8 | Comparative Example A-9 | Comparative Example A-10 |
|---|---|---|---|---|
| Dispersion medium | Dihydroterpineol | 11.15 | 11.50 | 11.84 |
| Reducing agent | TEG | 0.48 | 0.34 | 0.24 |
| | PEG300 | 0.55 | 0.48 | 0.33 |
| | PEG400 | 0.48 | 0.34 | 0.24 |
| Reduction aid | Triphenylphosphine | 0.98 | 0.98 | 0.98 |
| Copper sub-microparticles | CH-0200 | 67 | 67 | 67 |
| Copper microparticles | 2L3N | 34 | 34 | 34 |
| Total mass of copper particles (parts by mass) | | 100 | 100 | 100 |
| Bonding conditions (in nitrogen atmosphere) | Added pressure (MPa) | 0 | 0 | 0 |
| | Temperature (°C) | 300 | 300 | 300 |
| | Time (minutes) | 60 | 60 | 60 |
| Die shear strength (MPa) | | 15 | 10 | 9 |

### (Example B-1)

98.9 g of dihydroterpineol (manufactured by Nippon Terpene Chemicals, Inc.) as a dispersion medium and 1000 g of CH-0200 (manufactured by MITSUI MINING & SMELTING CO., LTD., product name, laser scattering method 50% volume average particle size 0.36 µm) as copper sub-microparticles were mixed, and the mixture was stirred for 30 minutes at a speed of rotation of 300 rpm by using a planetary mixer (manufactured by PRIMIX Corporation). The obtained mixture was subjected to a dispersion treatment once by using a Disperizer (manufactured by SINTOKOGIO, LTD.) under the conditions of a gap of 50 µm and a speed of rotation of 12000 rpm to obtain a 91% by mass dispersion liquid.

0.16 g of dihydroterpineol (manufactured by Nippon Terpene Chemicals, Inc.) as the remainder of the dispersion medium, 0.12 g of tetraethylene glycol (hereinafter, abbreviated to TEG) (manufactured by FUJIFILM Wako Pure Chemical Corporation) as a reducing agent, 0.18 g of polyethylene glycol 300 (hereinafter, abbreviated to PEG300) (manufactured by FUJIFILM Wako Pure Chemical Corporation) and 0.12 g of polyethylene glycol 400 (hereinafter, abbreviated to PEG400) (manufactured by FUJIFILM Wako Pure Chemical Corporation) as polyol-based compounds, 0.05 g of triethyl phosphate (manufactured by FUJIFILM Wako Pure chemical Corporation) as a reduction aid, 6.38 g of the 91% by mass dispersion liquid obtained as described above, and 2.73 g of 2L3N (manufactured by FUKUDA METAL FOIL & POWDER CO., LTD., product name, laser scattering method 50% volume average particle size 9.9 µm) together with 0.26 g of C3 (manufactured by FUKUDA METAL FOIL & POWDER CO., LTD., product name, laser scattering method 50% volume average particle size 37 µm) as copper microparticles were mixed, and the mixture was stirred at 2000 rpm under reduced pressure for 3 minutes by using a rotation-revolution rotary mixer (manufactured by THINKY CORPORATION, Awatori Rentaro ARE-310) to obtain a metal paste for bonding.

### (Example B-2)

A metal paste for bonding was each obtained in the same manner as in Example B-1, except that the feed amounts of the dispersion medium and the reduction aid were changed to the proportions shown in Table 6 (with respect to 100 parts by mass of the total mass of the copper particles, the mass of the reduction aid was 0.98 parts by mass).

### (Example B-3)

A metal paste for bonding was each obtained in the same manner as in Example B-1, except that the feed amounts of the dispersion medium and the reduction aid were changed to the proportions shown in Table 6 (with respect to 100 parts by mass of the total mass of the copper particles, the mass of the reduction aid was 1.64 parts by mass).

### (Example B-4)

A metal paste for bonding was obtained in the same manner as in Example B-1, except that tris(2-butoxyethyl) phosphate (manufactured by FUJIFILM Wako Pure Chemical Corporation) was used as the reduction aid instead of triethyl phosphate, and the feed amount of the reduction aid was changed to the proportion shown in Table 6 (with respect to 100 parts by mass of the total mass of the copper particles, the mass of the reduction aid was 0.98 parts by mass).

### (Comparative Example B-1)

A metal paste for bonding was obtained in the same manner as in Example B-1, except that a reduction aid was not blended, and the feed amount of the dispersion medium was changed to the proportion shown in Table 6.

**[Table 6]**

| | | Example B-1 | Example B-2 | Example B-3 | Example B-4 | Comparative Example B-1 |
|---|---|---|---|---|---|---|
| Dispersion medium | Dihydroterpineol | 8.32 | 7.88 | 7.23 | 7.88 | 8.86 |
| Reducing agent | TEG | 1.36 | 1.37 | 1.38 | 1.39 | 1.40 |
| | PEG300 | 2.05 | 2.06 | 2.07 | 2.08 | 2.09 |
| | PEG400 | 1.36 | 1.37 | 1.38 | 1.39 | 1.40 |
| Reduction aid | Triethyl phosphate | 0.55 | 0.98 | 1.64 | - | - |
| | Tris(2-butoxyethyl) phosphate | - | - | - | 0.98 | - |
| Copper sub-microparticles | CH-0200 | 66 | 66 | 66 | 66 | 66 |
| Copper microparticles | 2L3N | 31 | 31 | 31 | 31 | 31 |
| | C3 | 3 | 3 | 3 | 3 | 3 |
| Total mass of copper particles (parts by mass) | | 100 | 100 | 100 | 100 | 100 |
| Bonding conditions (in nitrogen atmosphere) | Added pressure (MPa) | 0 | 0 | 0 | 0 | 0 |
| | Temperature (°C) | 300 | 300 | 300 | 300 | 300 |
| | Time (minutes) | 60 | 60 | 60 | 60 | 60 |
| Die shear strength (MPa) | | 23 | 20 | 21 | 20 | 13 |

### Reference Signs List

1: first member, 1a: first base part, 1b: first metal layer, 2: sintered body, 3: second member, 3a: second base part, 3b: second metal layer, 4: semiconductor element, 4a: base part of semiconductor element, 4b: metal layer of semiconductor element, 5: lead frame, 5a: base part, 5b: metal layer, 6: mold resin, 7: wire, 8: lead frame, 8a: base part, 8b: metal layer, 100: bonded body, 200: semiconductor device.

## Claims

1. A metal paste for bonding, comprising:
metal particles;
a dispersion medium;
a reducing agent; and
a reduction aid,
wherein the metal particles contain copper particles,
the reduction aid includes a coordinating compound having electron back-donation properties, the coordinating compound is at least one selected from the group consisting of an organic phosphorus compound and an organic sulfur compound, and
the metal paste for bonding contains, as the reducing agent, 1.6 parts by mass or more and 10 parts by mass or less of a polyol-based compound with respect to 100 parts by mass of a total mass of the copper particles.

2. The metal paste for bonding according to claim 1, wherein the coordinating compound has a lone pair of electrons and a vacant π-electron orbital.

3. The metal paste for bonding according to claim 1, wherein the coordinating compound is at least one selected from the group consisting of an organic phosphorus compound represented by the following Formula (1) and an organic phosphorus compound represented by the following Formula (2): wherein 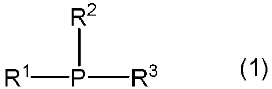 [in Formula (1), R¹, R², and R³ each independently represent a monovalent organic group or -OR (R represents a monovalent organic group); and R¹, R², and R³ may form a ring], 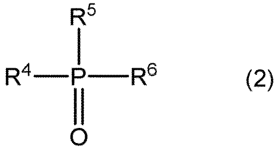 [in Formula (2), R⁴, R⁵, and R⁶ each independently represent a monovalent organic group or -OR (R represents a monovalent organic group); and one or more of R⁴, R⁵, and R⁶ are -OR (R represents a monovalent organic group.

4. The metal paste for bonding according to claim 1, wherein a content of the reduction aid is 0.5 parts by mass or more and 10 parts by mass or less with respect to 100 parts by mass of the total mass of the copper particles.

5. The metal paste for bonding according to claim 1,
wherein the copper particles include copper sub-microparticles having a volume average particle size of 0.15 µm or more and 0.8 µm or less and copper microparticles having a volume average particle size of 2 µm or more and 50 µm or less,
a sum of a content of the copper sub-microparticles and a content of the copper microparticles is 80% by mass or more based on the total mass of the metal particles, and
the content of the copper sub-microparticles is 30% by mass or more and 90% by mass or less based on a sum of a mass of the copper sub-microparticles and a mass of the copper microparticles.

6. The metal paste for bonding according to claim 5, wherein the copper microparticles are flake-shaped.

7. A method for manufacturing a bonded body, the method comprising:
a step of preparing a laminated body in which a first member, the metal paste for bonding according to any one of claims 1 to 6, and a second member are laminated in this order; and
a sintering step of sintering the metal paste for bonding in the laminated body.

8. The method for manufacturing a bonded body according to claim 7, wherein in the sintering step, the metal paste for bonding is sintered under no added pressure conditions in an oxygen-free atmosphere.

9. The method for manufacturing a bonded body according to claim 7, wherein at least one of the first member and the second member is a semiconductor element.

10. A bonded body comprising:
a first member;
a second member; and
a sintered body of the metal paste for bonding according to any one of claims 1 to 6, the sintered body bonding the first member and the second member.
